# NEUE EUROPÄISCHE PATENTSCHRIFT

(11) **EP 3 100 064 B2**
(45) Veröffentlichungstag und Bekanntmachung des Hinweises auf die Entscheidung über den Einspruch: **29.04.2026**
(45) Hinweis auf die Patenterteilung: 17.08.2022
(21) Anmeldenummer: 15701182.6
(22) Anmeldetag: 22.01.2015
(51) Int. Cl.: G01R 31/34

(54) **VORRICHTUNG SOWIE VERFAHREN ZUR FEHLERERKENNUNG IN MASCHINEN**
DEVICE AND METHOD FOR DETECTING FAULTS IN MACHINES
DISPOSITIF ET PROCÉDÉ DE DÉTECTION DE DÉFAUTS DANS DES MACHINES

(30) Priorität: 28.01.2014 DE 102014100945
(43) Veröffentlichungstag der Anmeldung: 07.12.2016
(73) Patentinhaber: KHS GmbH, 44143 Dortmund (DE)
(72) Erfinder: PREUSS, Rüdiger, 44797 Bochum (DE)
(74) Vertreter: Glück Kritzenberger Patentanwälte PartGmbB
(86) Internationale Anmeldenummer: PCT/EP2015/051186
(87) Internationale Veröffentlichungsnummer: WO 2015/113884

(56) Entgegenhaltungen:
- DE-A1- 102004 030 076
- US-A- 5 519 337
- US-A- 5 742 522
- US-A1- 2013 013 138
- US-A1- 2013 013 231
- US-A1- 2013 030 742
- US-B1- 6 640 196
- US-B1- 6 709 240
- US-B1- 6 709 240
- US-B1- 7 539 549

## Beschreibung

Die Erfindung bezieht sich auf ein Verfahren zur Fehlererkennung in einer Maschine gemäß Oberbegriff Patentanspruch 1 sowie auf eine Vorrichtung zur Fehlererkennung in einer Maschine gemäß Oberbegriff Patentanspruch 10.

Zur vorausschauenden Wartung und Instandhaltung eine Maschine ist es bekannt, zur frühzeitigen Erkennung und Lokalisierung von Fehlern mechanische Schwingungen zu erfassen und diese auszuwerten. Dabei werden an definierten Stellen der Maschine Schwingungssensoren angebracht, die zur Erfassung der mechanischen Schwingungen ausgebildet sind. Durch diese Schwingungssensoren können auftretende Schwingungen erkannt werden, die Rückschlüsse auf Fehler an der Maschine bzw. durchzuführende Wartungen an derselben zulassen. Das Anbringen von Schwingungssensoren an der Maschine ist zum einen störungsanfällig, da die Schwingungssensoren leicht beschädigt werden können. Darüber hinaus bedeutet das Anbringen von Schwingungssensoren einen zusätzlichen Aufwand und ist damit teuer.

Weiterhin ist es bei elektrisch angetriebenen Vorrichtungen bekannt, Fehler dadurch zu erkennen, dass elektrische Messgrößen, insbesondere die elektrische Leistungsaufnahme charakterisierende Messgrößen, beispielsweise der von einer elektrischen Antriebseinheit aufgenommene elektrische Strom einen vorgesehenen Grenzwert überschreiten. Das aus dem Stand der Technik bekannte Verfahren beruht auf der Tatsache, dass bei Elektromotoren die Stromstärke des durch den Elektromotor fließenden elektrischen Stroms von der mechanischen Belastung des Elektromotors abhängt. So führt eine steigende mechanische Belastung des Elektromotors zu einem Anstieg der Stromstärke und -in umgekehrter Weise- eine sinkende mechanische Belastung zu einem Abfallen der Stromstärke. Somit zieht eine Veränderung der mechanischen Belastung eines Elektromotors eine Veränderung der Stromaufnahme dieses Motors nach sich.

Durch das aus dem Stand der Technik bekannte Verfahren zur Erkennung von Fehlern wird der Betrag der Stromstärke dahingehend überprüft, ob die Stromstärke einen definierten Schwellenwert übersteigt. Bei Übersteigen wird beispielsweise ein Fehlererkennungssignal an einer Überwachungseinrichtung ausgegeben. Nachteilig an dem bekannten Verfahren ist, dass Fehler an der Maschine zwar vor einem kompletten Maschinenstillstand erkennbar sind und damit eine ungeplante Produktionsunterbrechung möglicherweise vermeidbar ist, jedoch in der Regel an der Maschine bereits erhebliche mechanische Schäden entstanden sind, welche durch aufwändige und kostenintensive Reparaturen zu beheben sind.

Ein Verfahren zur frühzeitigen Erkennung von Fehlern an elektrischen Antriebsmotoren an Fahrzeugen wurde durch die US 2013/0013231 vorgestellt. Diese Schrift beschreibt ein Verfahren für ein Fahrzeug mit einer Mehrzahl von elektrischen Antriebsmotoren, wobei für jeden Motor eine elektrische Signatur erzeugt wird. Diese elektrische Signatur repräsentiert eine oder mehrere charakteristische Merkmal(e) der elektrischen Energie, mit welcher der Motor versorgt wird. Zum Erkennen von Fehlern beinhaltet das Verfahren auch die Durchführung einer oder mehrerer Messungen an jedem der elektrischen Antriebsmotoren bzw. an dessen elektrischen Signaturen. Die durchgeführten Fehlermessungen gegen einen Hinweis auf den mechanischen Zustand des Motors. Das Verfahren beinhaltet weiterhin den Vergleich mit einer oder mehrerer Fehlermessungen von anderen Motoren innerhalb desselben Fahrzeugs und auch das Vorhersagen eines sich anbahnenden mechanischen Fehlers eines oder mehrerer der Motoren basierend auf dem Vergleich der Fehlermessungen des Motors.

Die Druckschrift US 5,519,337 A offenbart ein Verfahren zur Überwachung eines Motors eines elektrischen Geräts. Dabei werden Frequenzbereiche des Spektrums des elektrischen Stroms, der durch den Motor fließt, überwacht, um den Zustand des Motors zu evaluieren. Ein Verfahren gemäß dem Oberbegriff des Patentanspruches 1 wurde aus der Druckschrift US 6,709,240 B1 bekannt.

Ausgehend hiervon ist es Aufgabe der Erfindung, eine Vorrichtung zum Erkennen von Fehlern in einer Maschine anzugeben, mittels der auftretende Schäden bereits frühzeitig erkannt werden können und dabei eine geplante Maschinenwartung bereits vor dem Auftreten von komplexen mechanischen Schäden durchgeführt werden kann. Die Erfindung wird ausgehend vom Oberbegriff des unabhängigen Patentanspruchs 1 durch dessen kennzeichnende Merkmale gelöst. Eine Vorrichtung zum Erkennen von Fehlern in Maschinen ist Gegenstand des nebengeordneten Patentanspruchs 10.

Die Erfindung betrifft zunächst ein Verfahren zur Erkennung von Fehlern in einer Maschine. Die Maschine umfasst hierbei zumindest eine elektrische Antriebseinheit mittels der zumindest eine Baugruppe der Maschine angetrieben wird. Gemäß dem

Verfahren wird zunächst das Frequenzspektrum einer die elektrische Leistungsaufnahme der Antriebseinheit charakterisierenden Messgröße ermittelt. Die Messgröße kann hierbei jedwede elektrische Messgröße sein, die Rückschlüsse auf die Leistungsaufnahme der elektrischen Antriebseinheit zulässt. Anschließend wird in einem Analyseschritt das Frequenzspektrum dieser Messgröße hinsichtlich auf Fehler hinweisenden Auffälligkeiten ausgewertet. Diese Auswertung kann automatisiert durch eine Analyseeinheit oder durch Wartungspersonal erfolgen. Das Verfahren ist vorteilhaft, da durch die spektrale Analyse der die elektrische Leistungsaufnahme der Antriebseinheit charakterisierenden Messgröße periodische Schwankungen der Belastung der Antriebseinheit erkennbar werden und damit beispielsweise periodisch auftretende Kollisionen eines bewegten Maschinenelements mit einem weiteren Maschinenelement oder periodische Belastungsspitzen in einem Getriebe frühzeitig erkennbar werden.

Das Frequenzspektrum wird mit einem in der Vergangenheit aufgenommenen Referenzfrequenzspektrum verglichen. Bei Abweichen zumindest eines spektralen Anteils des Frequenzspektrums vom in der Vergangenheit aufgenommenen Referenzfrequenzspektrum wird ein Fehlererkennungssignal erzeugt.

Gemäß einem Ausführungsbeispiel der Erfindung umfasst die Maschine eine Vielzahl von Antriebseinheiten, wobei für mehrere oder alle dieser Antriebseinheiten jeweils das Frequenzspektrum einer die elektrische Leistungsaufnahme der Antriebseinheit charakterisierenden Messgröße ermittelt wird und in einem Analyseschritt die Frequenzspektren dieser Messgrößen hinsichtlich auf Fehler hinweisenden Auffälligkeiten ausgewertet werden. Damit wird sichergestellt, dass mehrere Antriebseinheiten gleichzeitig hinsichtlich eines Schwingungsverhaltens ihrer mechanischen Belastung überwacht werden.

Bevorzugt werden die Frequenzspektren jeweils mit einem in der Vergangenheit aufgenommenen Referenzfrequenzspektrum verglichen und bei Abweichen zumindest eines spektralen Anteils des jeweiligen Frequenzspektrums vom Referenzfrequenzspektrum ein Fehlererkennungssignal erzeugt. Vorzugsweise wird zudem ein Lokalisierungssignal erzeugt, mittels dem die Antriebseinheit definiert wird, an der die spektrale Abweichung vom Referenzfrequenzspektrum aufgetreten ist. In Abhängigkeit von der Antriebseinheit, an der eine periodische Belastungsänderung aufgetreten ist, kann damit eine Groblokalisierung des aufgetretenen Fehlers, d.h. eine örtliche Eingrenzung des Fehlers vorgenommen werden. Insbesondere kann auch die Frequenz ausgegeben und/oder zur weiteren Eingrenzung des Fehlers herangezogen werden. Die Frequenz lässt nämlich Rückschlüsse auf die Periodizität der Belastungsschwankungen zu, d.h. es kommen lediglich die mechanischen Bauteile als fehlerauslösend in Frage, die mit dieser Periodizität bewegt werden.

In einem weiteren Ausführungsbeispiel wird das zumindest eine Frequenzspektrum kontinuierlich oder in regelmäßigen Zeitabständen ermittelt. Damit kann fortlaufend oder nach Ablauf eines bestimmten Zeitintervalls das ermittelte Frequenzspektrum mit dem Referenzfrequenzspektrum verglichen und ein möglicherweise auftretender Fehler erkannt werden. Erfindungsgemäß wird das aktuell ermittelte Frequenzspektrum gleichzeitig mit mehreren in der Vergangenheit zu unterschiedlichen Zeitpunkten ermittelten Referenzfrequenzspektren verglichen, d.h. die zeitliche Veränderung des Frequenzspektrums wird basierend auf mehreren in der Vergangenheit zu unterschiedlichen Zeitpunkten aufgenommenen Referenzfrequenzspektren ermittelt. Dadurch kann das Fortschreiten eines auftretenden Fehlers analysiert und das Fehlererkennungssignal abhängig vom Fortschreiten des Fehlers erzeugt werden.

Das Referenzfrequenzspektrum ist ein im Neuzustand der Maschine aufgenommenes Frequenzspektrum. Alternativ ist das Referenzfrequenzspektrum ein Spektrum, das nach Verstreichen einer Betriebsdauer nach der Inbetriebnahme der Maschine aufgezeichnet wurde. Wie zuvor bereits ausgeführt, kann auch ein Vergleich mit mehreren zu unterschiedlichen Zeitpunkten aufgezeichneten Referenzfrequenzspektren erfolgen. Die Referenzfrequenzspektren können dabei in einer Speichereinheit abgelegt sein, auf die ein Analysemodul zugreifen kann. Alternativ kann die Speichereinheit auch in das Analysemodul integriert sein.

In einem weiteren Ausführungsbeispiel werden Amplitudenwerte der spektralen Anteile des ermittelten Frequenzspektrums mit diesen spektralen Anteilen zugeordneten Schwellwerten verglichen, wobei bei Überschreiten zumindest eines Schwellwerts durch den diesem Schwellwert zugeordneten Amplitudenwert das Fehlererkennungssignal erzeugt wird. Beispielsweise kann eine Schwelle festgelegt sein, wobei erst bei Überschreiten dieser Schwelle ein Fehlererkennungssignal erzeugt wird. Diese Schwelle kann frequenzabhängig sein, d.h. für verschiedene Frequenzen unterschiedliche Schwellwerte definieren. Die Schwelle kann insbesondere als Schwelle relativ zum Referenzfrequenzspektrum definiert sein, so dass erst bei Ansteigen eines spektralen Anteils um einen gewissen Prozentsatz ein Fehlererkennungssignal erzeugt wird. Damit kann einem Referenzfrequenzspektrum, das mehrere Spitzen bzw. Peaks im Spektrum aufweist, eine Schwellwertkurve zugeordnet sein, die frequenzabhängig ist und derart an das Referenzfrequenzspektrum angepasst ist, dass die Schwellwertkurve zu den Amplitudenwerten des Referenzfrequenzspektrums einen definierten absoluten oder relativen Abstand einhält. Der Abstand legt damit eine Toleranzgrenze fest, nach deren Überschreitung erst das Fehlererkennungssignal erzeugt wird. Die Schwelle oder Schwellwertkurve kann aus einer Vielzahl von diskreten Schwellwerten oder einer die Schwellwertkurve definierenden Schwellwertfunktion (z.B. einem Polynom) gebildet werden.

In einem weiteren Ausführungsbeispiel wird das Frequenzspektrum der die elektrische Leistungsaufnahme der Antriebseinheit charakterisierenden Messgröße aus dem zeitlichen Verlauf der Amplitude dieser Messgröße durch eine Transformation in den Frequenzbereich erhalten. Beispielsweise können mehrere diskrete Amplitudenwerte zu unterschiedlichen Zeitpunkten aufgenommen werden und mittels eines diskreten Transformationsverfahrens in den Frequenzbereich transformiert werden, um das Frequenzspektrum zu erhalten. Für die Transformation können jegliche aus dem Stand der Technik bekannte Transformationsverfahren verwendet werden, insbesondere eine Fourier-Transformation oder eine Laplace-Transformation.

In einem weiteren Ausführungsbeispiel ist die die elektrische Leistungsaufnahme der Antriebseinheit charakterisierende Messgröße der elektrische Strom, d.h. der von der Antriebseinheit aufgenommene elektrische Strom. Der von einer elektrischen Antriebseinheit aufgenommene elektrische Strom hängt direkt von der mechanischen Belastung dieser Antriebseinheit ab und unterliegt damit denselben Schwankungen wie die mechanische Belastung der Antriebseinheit. Alternativ kann auch das Produkt aus dem von der Antriebseinheit aufgenommenen elektrischen Strom und der an der elektrischen Antriebseinheit abfallenden Spannung als Messgröße verwendet werden.

In einem weiteren Ausführungsbeispiel wird die die elektrische Leistungsaufnahme der Antriebseinheit charakterisierende Messgröße durch Analyse einer die elektrische Leistungsaufnahme der gesamten Maschine charakterisierenden Messgröße, durch Analyse einer die elektrische Leistungsaufnahme einer Gruppe von Antriebseinheiten charakterisierenden Messgröße und/oder durch Analyse einer die elektrische Leistungsaufnahme einer einzelnen Antriebseinheit charakterisierenden Messgröße erhalten. Vorteilhafterweise wird die Leistungsaufnahme der einzelnen Antriebseinheiten der Maschine jeweils unabhängig voneinander analysiert, da bei Analyse einer Messgröße, deren Betrag von der Leistungsaufnahme einer Gruppe von Antriebseinheiten oder von der Leistungsaufnahme der Gesamtmaschine abhängt, die Fehleranalyse erschwert wird, da eine Zuordnung einer erkannten Erhöhung einer Amplitude eines spektralen Anteils zu einer bestimmten Antriebseinheit und damit eine Lokalisierung des Fehlers nicht möglich ist.

In einem weiteren Ausführungsbeispiel ist jeder Antriebseinheit oder einer Gruppe von Antriebseinheiten eine Steuereinheit zugeordnet. Durch diese Steuereinheit wird der Zeitverlauf der die elektrische Leistungsaufnahme der Antriebseinheit charakterisierenden Messgröße und/oder das Frequenzspektrum dieser Messgröße bereitgestellt. Die Steuereinheit kann hierbei beispielsweise eine Antriebssteuereinheit sein, die die Regelelektronik der Antriebseinheit enthält und mittels der die Regelung der elektrischen Antriebseinheit, beispielsweise die Drehzahlregelung erfolgt.

Des Weiteren betrifft die Erfindung eine Vorrichtung zur Erkennung von Fehlern in einer Maschine, wobei die Maschine zumindest eine elektrische Antriebseinheit zum Antrieb einer Baugruppe der Maschine umfasst. Die Vorrichtung weist ein Analysemodul auf, mittels dem das Frequenzspektrum einer die elektrische Leistungsaufnahme der Antriebseinheit charakterisierenden Messgröße ermittelt und hinsichtlich auf Fehler hinweisenden Auffälligkeiten ausgewertet wird.

Das Frequenzspektrum wird mit einem in der Vergangenheit aufgenommenen Referenzfrequenzspektrum verglichen. Das Analysemodul ist ferner zur Ermittlung der Abweichung zumindest eines spektralen Anteils des Frequenzspektrums von einem in der Vergangenheit aufgenommenen Referenzfrequenzspektrum und zur Erzeugung eines Fehlererkennungssignals ausgebildet.

In einem weiteren Ausführungsbeispiel umfasst die Maschine eine Vielzahl von Antriebseinheiten, wobei ein oder mehrere Analysemodule vorgesehen sind, mittels denen für mehrere oder alle dieser Antriebseinheiten jeweils das Frequenzspektrum einer die elektrische Leistungsaufnahme der Antriebseinheit charakterisierenden Messgröße ermittelt und hinsichtlich auf Fehler hinweisenden Auffälligkeiten analysiert wird.

Bevorzugt werden durch das zumindest eine Analysemodul die Frequenzspektren jeweils mit einem dem jeweiligen Frequenzspektrum zugeordneten Referenzfrequenzspektrum verglichen.

In einem weiteren Ausführungsbeispiel ist das Analysemodul bei Abweichen zumindest eines spektralen Anteils des jeweiligen Frequenzspektrums vom Referenzfrequenzspektrum zur Erzeugung eines Fehlererkennungssignals und/oder zur Erzeugung eines die jeweilige Antriebseinheit charakterisierenden Lokalisierungssignals ausgebildet.

Erfindungsgemäb ist das Analysemodul zur Ermittlung der zeitlichen Veränderung des Frequenzspektrums basierend auf mehreren in der Vergangenheit zu unterschiedlichen Zeitpunkten aufgenommenen Referenzfrequenzspektren ausgebildet.

In einem weiteren Ausführungsbeispiel ist jeder Antriebseinheit oder einer Gruppe von Antriebseinheiten eine Steuereinheit zugeordnet, wobei der Zeitverlauf der die elektrische Leistungsaufnahme der Antriebseinheit charakterisierenden Messgröße und/oder das Frequenzspektrum dieser Messgröße durch die Steuereinheit bereitgestellt wird.

Weiterbildungen, Vorteile und Anwendungsmöglichkeiten der Erfindung ergeben sich auch aus der nachfolgenden Beschreibung von Ausführungsbeispielen und aus den Figuren.

Die Erfindung wird im Folgenden anhand der Figuren an mehreren Ausführungsbeispielen näher erläutert. Es zeigen:
- Fig. 1: beispielhaft in einer schematischen Blockdarstellung eine Maschine mit einer Vorrichtung zur Erfassung von Fehlern in einem ersten Ausführungsbeispiel;
- Fig. 2: beispielhaft in einer schematischen Blockdarstellung eine Maschine mit einer Vorrichtung zur Erfassung von Fehlern in einem zweiten Ausführungsbeispiel;
- Fig. 3: beispielhaft ein einer Antriebseinheit zugeordnetes Referenzfrequenzspektrum des von der Antriebseinheit aufgenommenen elektrischen Stroms;
- Fig. 4: beispielhaft ein einer Antriebseinheit zugeordnetes, aufgenommenes Frequenzspektrum mit einer einen Fehler indizierenden spektralen Überhöhung (gekennzeichnet durch Pfeil);
- Fig. 5: beispielhaft ein weiteres Beispiel eines einer Antriebseinheit zugeordneten, aufgenommenen Frequenzspektrums mit einer einen Fehler indizierenden spektralen Überhöhung (gekennzeichnet durch Pfeil).

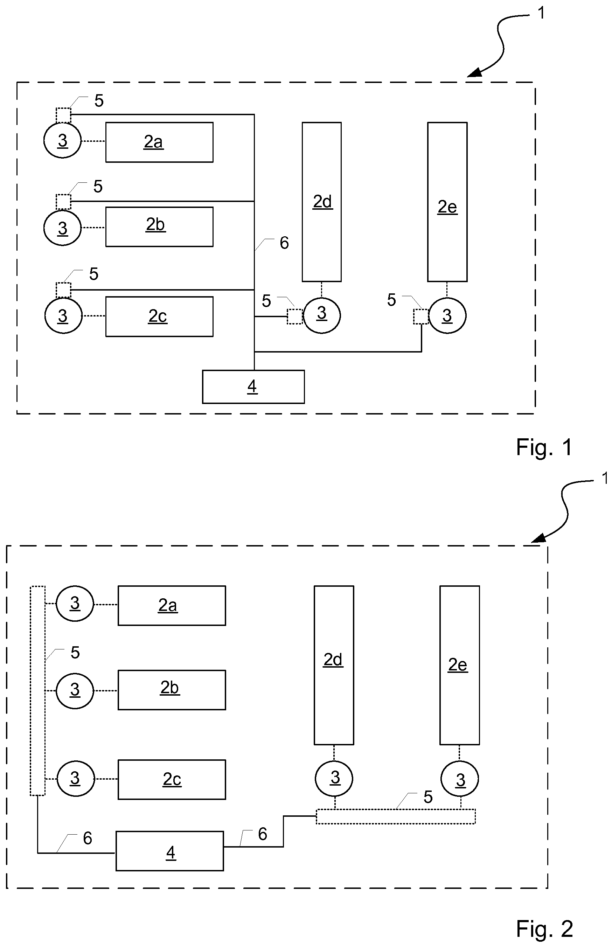

In Figur 1 ist mit dem Bezugszeichen 1 eine Maschine ist, insbesondere eine Maschine zum Behandeln von Behältern gezeigt. Die Maschine 1 weist mehrere Baugruppen 2a, 2b, 2c, 2d, 2e auf, denen jeweils eine elektrische Antriebseinheit 3 zugeordnet ist. Die elektrische Antriebseinheit 3 kann insbesondere durch einen Elektromotor, bevorzugt durch einen Servomotor gebildet werden. Die Antriebseinheiten 3 sind antriebsmäßig mit jeweils einer Baugruppe 2a - 2e gekoppelt, d.h. die jeweilige Baugruppe 2a - 2e wird durch eine Antriebseinheit 3 angetrieben. Es versteht sich, dass auch andere Konfigurationen von der Erfindung umfasst sind, beispielsweise dass eine Baugruppe 2a - 2e antriebsmäßig mit mehreren Antriebseinheiten 3 gekoppelt ist oder dass mehrere Baugruppen 2a - 2e durch eine einzige Antriebseinheit 3 angetrieben werden.

Die Maschine 1 umfasst des Weiteren zumindest ein Analysemodul 4 oder die Maschine 1 weist zumindest eine Verbindungsschnittstelle auf, über die die Maschine 1 mit einem Analysemodul 4 koppelbar ist. Mittels des Analysemoduls 4 kann das Frequenzspektrum einer die elektrische Leistungsaufnahme einer Antriebseinheit 3 charakterisierenden Messgröße, beispielsweise dem elektrischen Strom, der durch die Antriebseinheit 3 fließt, ermittelt werden. Dieses Frequenzspektrum kann in einem Analyseschritt ausgewertet und dabei hinsichtlich auftretender Fehler analysiert werden. Dies kann beispielsweise durch das Analysemodul 4 selbst, d.h. automatisch erfolgen oder das Analysemodul 4 weist eine graphische Benutzerschnittstelle, beispielsweise ein Display oder einen Monitor auf, mittels dem das Frequenzspektrum darstellbar ist. Damit kann Bedien- oder Wartungspersonal das Frequenzspektrum auswerten und auftretende Fehler durch Veränderungen im Frequenzspektrum erkennen.

Das Analysemodul 4 ist zum Vergleich des Frequenzspektrums der Messgröße mit einem in der Vergangenheit aufgenommenen Referenzfrequenzspektrum ausgebildet. Dabei wird durch das Analysemodul 4 die Abweichung zumindest eines spektralen Anteils des Frequenzspektrums zu einem korrespondierenden spektralen Anteil des in der Vergangenheit aufgenommenen Referenzfrequenzspektrums ermittelt. Für den Fall, dass die Abweichung über einem festgelegten Schwellwert liegt, kann durch das Analysemodul ein Fehlererkennungssignal erzeugt werden. Der Schwellwert kann hierbei ein Absolutwert sein, d.h. beispielsweise ein einer bestimmten Frequenz zugeordneter Amplitudenwert. Alternativ kann der Schwellwert als relativer Schwellwert definiert sein, sodass beispielsweise Überschreitungen der Amplitudenwerte des Referenzfrequenzspektrums um einen festgelegten Prozentwert zur Erzeugung eines Fehlererkennungssignals führen. In dem in Figur 1 gezeigten Ausführungsbeispiel ist jeder Antriebseinheit 3 jeweils eine Steuereinheit 5 zugeordnet, über welche die Ansteuerung der jeweiligen Antriebseinheit 3 erfolgt. Die Steuereinheiten 5 können hierbei eine Steuerelektronik enthalten, mittels der die Drehgeschwindigkeit, die Beschleunigung und/oder die Winkelposition einer Antriebswelle der Antriebseinheit 3 steuerbar ist. Insbesondere kann es sich bei der Antriebseinheit 3 um einen Servoantrieb handeln.

Die Steuereinheit 5 kann insbesondere zur Bestimmung des zeitlichen Verlaufs einer die elektrische Leistungsaufnahme der Antriebseinheit charakterisierenden Messgröße, beispielsweise des die elektrische Antriebseinheit 3 durchfließenden elektrischen Stroms ausgebildet sein. Die Steuereinheit 5 ist vorzugsweise mit dem Analysemodul 4 mittels einer Datenleitung 6 zum Austausch von Daten gekoppelt. Die Steuereinheit 5 kann beispielsweise über diese Datenleitung 6 zeitabhängige Amplitudenmesswerte der jeweiligen Messgröße an das Analysemodul 4 übertragen. Diese Datenübertragung kann zum einen live bzw. kontinuierlich erfolgen, d.h. die ermittelten zeitabhängigen Amplitudenmesswerte werden unmittelbar ohne Zwischenspeicherung an das Analysemodul übertragen. Alternativ kann die Steuereinheit 5 auch eine Speichereinheit umfassen, in der die ermittelten Amplitudenmesswerte vor ihrer Übertragung an das Analysemodul 4 zwischengespeichert werden. Damit ist beispielsweise eine Übertragung der ermittelten zeitabhängigen Amplitudenmesswerte nach Ablauf eines festlegbaren Zeitintervalls oder bei Eintritt definierbarer, die Übertragung auslösender Bedingungen (z.B. bestimmter Maschinenzustand) möglich. Gemäß dem in Figur 1 gezeigten Ausführungsbeispiel sind die ermittelten zeitabhängigen Amplitudenmesswerte beispielsweise jeweils einer Antriebseinheit 3 zugeordnet, d.h. für jede Antriebseinheit 3 werden eigenständige zeitabhängige Amplitudenmesswerte der die elektrische Leistungsaufnahme der Antriebseinheit charakterisierenden Messgröße ermittelt.

Das Analysemodul 4 ist vorzugsweise zur spektralen Analyse der empfangenen, den jeweiligen Antriebseinheiten 3 zugeordneten Messgrößen ausgebildet. Insbesondere kann durch das Analysemodul 4 durch Transformation der empfangenen zeitabhängigen Amplitudenmesswerte der Messgröße in den Frequenzbereich ein Frequenzspektrum ermittelt werden, das den jeweiligen Antriebseinheiten 3 zugeordnet ist und Informationen hinsichtlich des Schwingungsgehalts der Messgröße enthält. Beispielsweise kann eine Antriebseinheit 3 der Maschine 1 in periodischen Abständen eine erhöhte punktuelle Belastung erfahren, die zu einer periodisch erhöhten Leistungsaufnahme der jeweiligen Antriebseinheit 3, d.h. insbesondere einem Anstieg des elektrischen Stroms führt, der durch die Antriebseinheit 3 fließt. Dies kann beispielsweise von einem Lagerschaden oder von einer stellungsabhängigen Kollision eines von der Antriebseinheit 3 bewegten Maschinenelements herrühren. Diese zeitlich periodischen Belastungsschwankungen führen zu zeitlich periodischen Schwankungen der Leistungsaufnahme der jeweiligen Antriebseinheit 3 und damit zu zeitlich periodischen Schwankungen des Stroms, der die elektrische Antriebseinheit 3 durchfließt. Die Transformation der zeitabhängigen Messgröße in den Frequenzbereich führt damit zu einer Spitze bzw. Peak im Frequenzspektrum dieser Messgröße, d.h. zu einer spektralen Überhöhung an einer definierten Frequenz, die der zeitlichen Periodizität entspricht, mit der die Leistungsschwankungen auftreten (f = 1/T, wobei T die zeitliche Periode der Leistungsschwankung ([s]) und f die Frequenz [Hz] ist). Die Transformation des Zeitsignals in den Frequenzbereich kann durch jegliche aus dem Stand der Technik bekannte Transformationsverfahren, insbesondere durch eine Fourier-Transformation oder eine Laplace-Transformation, erfolgen. Für den Fall, dass durch die Steuereinheiten 5 zeitlich diskrete Amplitudenwerte der Messgröße bereitgestellt werden, kann insbesondere ein diskretes Transformationsverfahren, beispielsweise eine diskrete Fourier-Transformation (DFT) vollzogen werden.

Das Analysemodul 4 kann insbesondere für jede Antriebseinheit 3 getrennt die zeitabhängige Messgröße empfangen und damit getrennt für jede Antriebseinheit 3 ein Frequenzspektrum für diese zeitabhängige Messgröße bestimmen. Für den Fall, dass eines der ermittelten Frequenzspektren einen spektralen Anteil aufweist, der oberhalb eines definierten Schwellwertes liegt, erzeugt das Analysemodul 4 vorzugsweise ein Fehlererkennungssignal. Optional kann auch ein Lokalisierungssignal erzeugt werden, das angibt, welche Antriebseinheit 3 die Erzeugung des Fehlererkennungssignals verursacht hat. Dadurch wird es möglich, dass ein auftretender Fehler schneller lokalisierbar ist.

In einem Ausführungsbeispiel ist es möglich, dass fußend auf dem zeitlichen Verlauf der Messgröße das Frequenzspektrum kontinuierlich oder quasi-kontinuierlich (beispielsweise durch Verzögerungen durch Datenübertragung und Berechnung des Frequenzspektrums) bestimmt wird und ein kontinuierlicher bzw. quasikontinuierlicher Vergleich mit einem Referenzfrequenzspektrum erfolgt. Alternativ ist es möglich, dass das Frequenzspektrum der die Leistungsaufnahme der Antriebseinheit charakterisierenden Messgröße in regelmäßigen Zeitabständen ermittelt wird, und der Vergleich mit dem Frequenzspektrum ebenfalls in regelmäßigen Zeitabständen erfolgt.

Das Referenzfrequenzspektrum kann ein im Neuzustand der Maschine aufgenommenes Frequenzspektrum sein, das in einer dafür vorgesehenen Speichereinheit abgelegt ist. Die Speichereinheit kann insbesondere im Analysemodul 4 angeordnet sein oder eine externe Speichereinheit sein, mit der das Analysemodul 4 gekoppelt ist und auf die das Analysemodul 4 zur Durchführung des spektralen Vergleichs zugreifen kann.

Alternativ oder zusätzlich können in dieser Speichereinheit mehrere in der Vergangenheit zu unterschiedlichen Zeitpunkten aufgenommene Referenzfrequenzspektren abgelegt sein. Beispielsweise kann ein Referenzfrequenzspektrum das im Neuzustand der Maschine aufgenommene Frequenzspektrum einer Antriebseinheit 3 und die weiteren Referenzfrequenzspektren die in bestimmten Zeitintervallen oder nach einer bestimmten Betriebsdauer jeweils aufgenommenen Frequenzspektren dieser Antriebseinheit 3 sein. Dadurch lässt sich der zeitliche Verlauf der Änderung des Frequenzspektrums über die Zeit ermitteln, so dass schleichend auftretende Fehler leichter erkannt werden können.

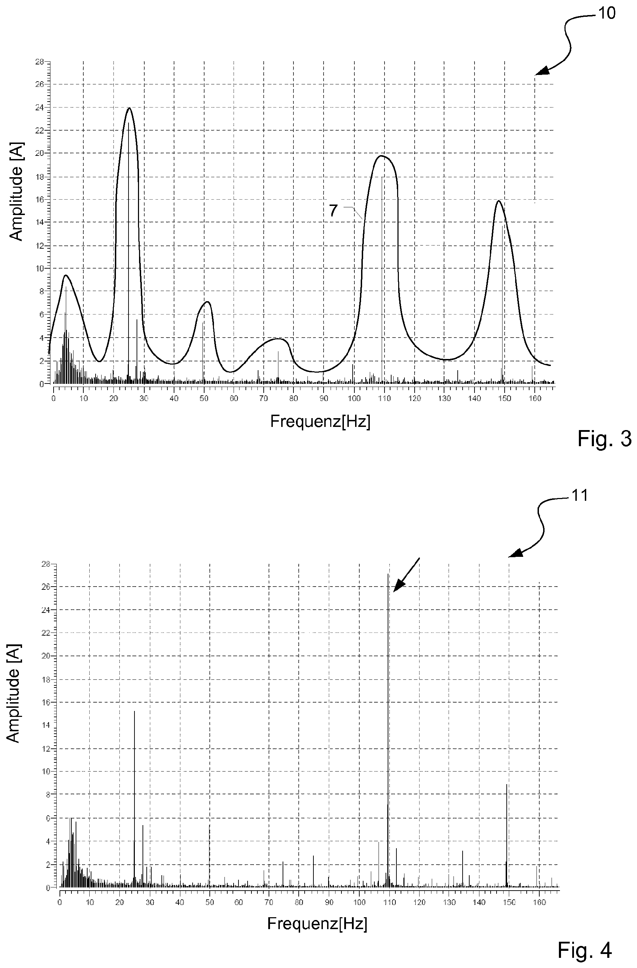

Figur 2 zeigt ein alternatives Ausführungsbeispiel der Maschine 1, die ebenfalls eine Vielzahl von Antriebseinheiten 3 aufweist, die antriebsmäßig mit den Baugruppen 2a - 2e gekoppelt sind. Unterschiedlich zu dem in Figur 1 gezeigten Ausführungsbeispiel ist einer Gruppe von Antriebseinheiten 3 jeweils eine Steuereinheit 5 zugeordnet, d.h. eine Steuereinheit 5 steuert mehrere Antriebseinheiten 3. Die Steuereinheiten 5 können für jede Antriebseinheit 3 der Gruppe von Antriebseinheiten 3 getrennt jeweils ein die elektrische Leistungsaufnahme dieser Antriebseinheit charakterisierende Messgröße erfassen oder aber auch für die Gruppe von Antriebseinheiten 3 insgesamt eine gemeinsame Messgröße ermitteln, die die summierte Leistungsaufnahme dieser Gruppe von Antriebseinheiten 3 wiederspiegelt. Die Messgröße ist hierbei vorzugsweise ein zeitabhängiges Signal, insbesondere die Amplitude bzw. der Betrag des durch die jeweilige Antriebseinheit 3 oder die Gruppe von Antriebseinheiten 3 fließenden elektrischen Stroms. Wie bereits bevor in Bezug auf die Figur 1 beschrieben, wird die zeitabhängige Messgröße bzw. die zeitabhängigen Messgrößen an das Analysemodul 4 übertragen, das zur Transformation der zeitabhängigen Messgröße in den Frequenzbereich ausgebildet ist. Das erhaltene Frequenzspektrum kann damit einer Gruppe von Antriebseinheiten 3 zugeordnet sein. Die Funktionalität der Steuereinheiten 5 und des Analysemoduls 4 entspricht im Übrigen den zuvor in Bezug auf Figur 1 beschriebenen Funktionalitäten. Figur 3 bis 5 zeigen beispielhaft Frequenzspektren 10, 11, 12 des von einer Antriebseinheit 3 aufgenommenen elektrischen Stroms, wobei die Abszisse die jeweiligen Frequenzen [Hz] und die Koordinate die Amplituden bzw. Beträge des Stroms [A] angibt. Das in Figur 3 gezeigte Spektrum ist insbesondere ein Referenzfrequenzspektrum 10, das beispielsweise im Neuzustand einer Maschine 1 aufgenommen wurde und beispielsweise dem Frequenzspektrum des eine Antriebseinheit 3 durchfließenden elektrischen Stroms entspricht. Das Referenzfrequenzspektrum 10 zeigt bereits mehrere Spitzen oder Peaks an unterschiedlichen Frequenzen.

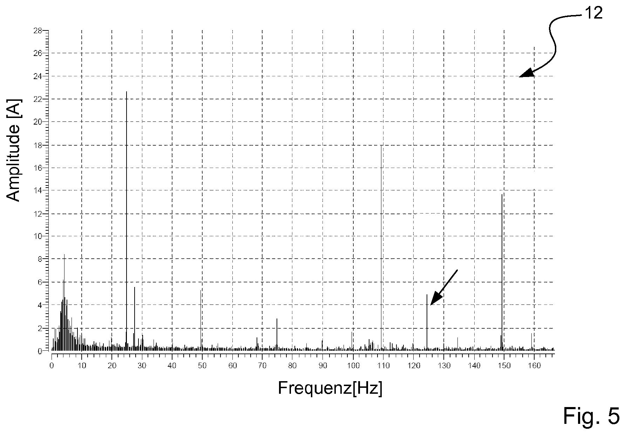

Figuren 4 und 5 zeigen unterschiedliche Frequenzspektren 11, 12, die beispielsweise jeweils den spektralen Verlauf des von einer Antriebseinheit 3 aufgenommenen elektrischen Stroms nach einer längeren Betriebsdauer einer Maschine 1 wiederspiegeln. Wie ein Vergleich der Frequenzspektren zwischen Figur 3 und Figur 4 erkennen lässt, weist das in Figur 4 gezeigte Frequenzspektrum 11 eine höhere Welligkeit auf, d.h. es treten mehrere Peaks zu unterschiedlichen Frequenzen auf. Insbesondere auffällig ist der mit dem Pfeil gekennzeichnete Peak, der sich im Vergleich zu dem Referenzfrequenzspektrum 10 gemäß Figur 3 wesentlich erhöht hat. Dem Referenzfrequenzspektrum 10 aus Figur 3 kann eine Schwellwertkurve 7 zugeordnet sein, die Schwellwerte in Abhängigkeit von der Frequenz angibt. Vorzugsweise ist die Schwellwertkurve 7 an das Referenzfrequenzspektrum 10, d.h. den spektralen Verlauf der Amplitude der Messgröße angepasst. Die Schwellwertkurve 7 kann dabei durch eine Vielzahl von frequenzabhängigen, d.h. jeweils einer definierten Frequenz zugeordneten Schwellwerten gebildet werden, wobei die Beträge dieser Schwellwerte jeweils an die Amplitude des spektralen Anteils an dieser definierten Frequenz angepasst sind. Beispielsweise kann der Schwellwert durch einen Prozentwert festgelegt werden, der angibt, um wie viel Prozent der Schwellwert des spektralen Anteils oberhalb der Amplitude dieses spektralen Anteils liegt. Für den Fall, dass ein spektraler Anteil des Spektrums diese spektrale Schwellwertkurve 7 übersteigt, wird ein Fehlererkennungssignal erzeugt.

Durch die Zuordnung des Referenzfrequenzspektrums 10 und der Frequenzspektren 11, 12 zu einer definierten Antriebseinheit 3 oder zu einer Gruppe von Antriebseinheiten 3 kann eine Lokalisierung bzw. eine grobe Lokalisierung des Fehlers vorgenommen werden, da ein plötzlich auftretender oder in der Amplitude ansteigender Peak im Frequenzspektrum 11, 12 auf eine erhöhte Leistungsaufnahme der diesem Frequenzspektrum 11, 12 zugeordneten Antriebseinheit 3 hinweist, und damit auf einen Defekt in der mit dieser Antriebseinheit 3 gekoppelten Baugruppe 2a - 2e zurückzuführen ist.

Eine weitere Fehlerlokalisierung kann aufgrund der Frequenz vorgenommen werden, an der der Peak im Frequenzspektrum 11, 12 auftritt. Die Frequenz lässt nämlich Rückschlüsse auf Bauteile innerhalb der Baugruppe 2a - 2e zu, die beispielsweise mit einer Frequenz bewegt werden, die der Frequenz entspricht, an der der spektrale Peak auftritt. Figur 5 zeigt anhand eines weiteren Frequenzspektrums 12 ein weiteres Beispiel eines auftretenden Fehlers, und zwar wiederum an der mit dem Pfeil gekennzeichneten Stelle. Wie ein Vergleich mit dem Referenzfrequenzspektrum 10 gemäß Figur 3 zeigt, ist im Bereich von etwa 125Hz ein neuer, d.h. im Referenzfrequenzspektrum 10 nicht vorhandener Peak entstanden, der auf einen auftretenden Fehler zurückzuführen ist. Für den Fall, dass dieser Peak einen festgelegten Schwellwert bzw. die Schwellwertkurve 7 übersteigt, wird ein Fehlererkennungssignal erzeugt.

Die Erfindung wurde voranstehend an mehreren Ausführungsbeispielen beschrieben.

### Bezugszeichenliste

- 1: Maschine
- 2a - 2e: Baugruppe
- 3: Antriebseinheit
- 4: Analysemodul
- 5: Steuereinheit
- 6: Datenleitung
- 7: Schwellwertkurve
- 10: Referenzfrequenzspektrum
- 11, 12: Frequenzspektrum

## Patentansprüche

1. Verfahren zur Erkennung von Fehlern in einer Maschine (1) zum Behandeln von Behältern umfassend zumindest eine elektrische Antriebseinheit (3) zum Antrieb einer Baugruppe (2a - 2e) der Maschine (1), wobei das Frequenzspektrum einer die elektrische Leistungsaufnahme der Antriebseinheit (3) charakterisierenden Messgröße ermittelt wird und wobei in einem Analyseschritt das Frequenzspektrum der Messgröße hinsichtlich auf Fehler hinweisenden Auffälligkeiten ausgewertet wird, wobei das Frequenzspektrum (11, 12) mit einem Referenzfrequenzspektrum (10) verglichen wird, wobei bei Abweichen zumindest eines spektralen Anteils des Frequenzspektrums (11, 12) vom Referenzfrequenzspektrum (10) ein Fehlererkennungssignal erzeugt wird und wobei das Referenzfrequenzspektrum (10) ein im Neuzustand der Maschine aufgenommenes Frequenzspektrum ist oder ein Spektrum, das nach Verstreichen einer Betriebsdauer nach der Inbetriebnahme der Maschine (1) aufgezeichnet wurde, **dadurch gekennzeichnet, dass** die zeitliche Veränderung des Frequenzspektrums (11, 12) basierend auf mehreren in der Vergangenheit zu unterschiedlichen Zeitpunkten aufgenommenen Referenzfrequenzspektren (10) ermittelt wird, indem das aktuell ermittelte Frequenzspektrum (11, 12) gleichzeitig mit mehreren in der Vergangenheit zu unterschiedlichen Zeitpunkten ermittelten Referenzfrequenzspektren (10) verglichen wird.

2. Verfahren nach Anspruch 1, **dadurch gekennzeichnet, dass** die Maschine (1) eine Vielzahl von Antriebseinheiten (3) umfasst, dass für mehrere oder alle dieser Antriebseinheiten (3) jeweils das Frequenzspektrum (11, 12) einer die elektrische Leistungsaufnahme der Antriebseinheit (3) charakterisierenden Messgröße ermittelt wird, und dass in einem Analyseschritt die Frequenzspektren der Messgrößen hinsichtlich auf Fehler hinweisenden Auffälligkeiten ausgewertet werden.

3. Verfahren nach Anspruch 2, **dadurch gekennzeichnet, dass** die Frequenzspektren (11, 12) jeweils mit einem Referenzfrequenzspektrum (10) verglichen werden und dass bei Abweichen zumindest eines spektralen Anteils des jeweiligen Frequenzspektrums (11, 12) vom Referenzfrequenzspektrum (10) ein Fehlererkennungssignal und/oder ein die jeweilige Antriebseinheit (3) charakterisierendes Lokalisierungssignal erzeugt wird.

4. Verfahren nach Anspruch 1, **dadurch gekennzeichnet, dass** das zumindest eine Frequenzspektrum (11, 12) kontinuierlich oder in regelmäßigen Zeitabständen ermittelt wird.

5. Verfahren nach einem der vorhergehenden Ansprüche, **dadurch gekennzeichnet, dass** Amplitudenwerte der spektralen Anteile des ermittelten Frequenzspektrums (11, 12) mit diesen spektralen Anteilen zugeordneten Schwellwerten verglichen werden und dass bei Überschreiten zumindest eines Schwellwerts durch den diesem Schwellwert zugeordneten Amplitudenwert das Fehlererkennungssignal erzeugt wird.

6. Verfahren nach einem der vorhergehenden Ansprüche, **dadurch gekennzeichnet, dass** das Frequenzspektrum (11, 12) der die elektrische Leistungsaufnahme der Antriebseinheit (3) charakterisierenden Messgröße aus dem zeitlichen Verlauf der Amplitude dieser Messgröße durch eine Transformation in den Frequenzbereich erhalten wird.

7. Verfahren nach einem der vorhergehenden Ansprüche, **dadurch gekennzeichnet, dass** die die elektrische Leistungsaufnahme der Antriebseinheit (3) charakterisierende Messgröße der elektrische Strom ist.

8. Verfahren nach einem der vorhergehenden Ansprüche, **dadurch gekennzeichnet, dass** die die elektrische Leistungsaufnahme der Antriebseinheit (3) charakterisierende Messgröße durch Analyse einer die elektrische Leistungsaufnahme der gesamten Maschine (1) charakterisierenden Messgröße, durch Analyse einer die elektrische Leistungsaufnahme einer Gruppe von Antriebseinheiten (3) charakterisierenden Messgröße und/oder durch Analyse einer die elektrische Leistungsaufnahme einer einzelnen Antriebseinheit (3) charakterisierenden Messgröße erhalten wird.

9. Verfahren nach einem der vorhergehenden Ansprüche, **dadurch gekennzeichnet, dass** jeder Antriebseinheit (3) oder einer Gruppe von Antriebseinheiten (3) eine Steuereinheit (5) zugeordnet ist und der Zeitverlauf der die elektrische Leistungsaufnahme der Antriebseinheit charakterisierende Messgröße und/oder das Frequenzspektrum dieser Messgröße durch die Steuereinheit (5) bereitgestellt wird.

10. Vorrichtung zur Erkennung von Fehlern in einer Maschine (1) zum Behandeln von Behältern umfassend zumindest eine elektrische Antriebseinheit (3) zum Antrieb einer Baugruppe (2a-2e) der Maschine (1), wobei ein Analysemodul (4) vorgesehen ist, mittels dem das Frequenzspektrum (11, 12) einer die elektrische Leistungsaufnahme der Antriebseinheit (3) charakterisierenden Messgröße ermittelt und hinsichtlich auf Fehler hinweisenden Auffälligkeiten ausgewertet wird, wobei das Frequenzspektrum mit einem Referenzfrequenzspektrum (10) verglichen wird, wobei das Analysemodul (4) zur Ermittlung der Abweichung zumindest eines spektralen Anteils des Frequenzspektrums (11, 12) vom Referenzfrequenzspektrum (10) und zur Erzeugung eines Fehlererkennungssignals ausgebildet ist und wobei das Referenzfrequenzspektrum (10) ein im Neuzustand der Maschine aufgenommenes Frequenzspektrum ist oder ein Spektrum, das nach Verstreichen einer Betriebsdauer nach der Inbetriebnahme der Maschine (1) aufgezeichnet wurde, **dadurch gekennzeichnet, dass** das Analysemodul (4) zur Ermittlung der zeitlichen Veränderung des Frequenzspektrums (11, 12) basierend auf mehreren in der Vergangenheit zu unterschiedlichen Zeitpunkten aufgenommenen Referenzfrequenzspektren (10) ausgebildet ist, indem das aktuell ermittelte Frequenzspektrum (11, 12) gleichzeitig mit mehreren in der Vergangenheit zu unterschiedlichen Zeitpunkten ermittelten Referenzfrequenzspektren (10) verglichen wird.

11. Vorrichtung nach Anspruch 10, **dadurch gekennzeichnet, dass** die Maschine (1) eine Vielzahl von Antriebseinheiten (3) umfasst, dass ein oder mehrere Analysemodule (4) vorgesehen sind, mittels denen für mehrere oder alle dieser Antriebseinheiten (3) jeweils das Frequenzspektrum einer die elektrische Leistungsaufnahme der Antriebseinheit (3) charakterisierenden Messgröße ermittelt und hinsichtlich auf Fehler hinweisenden Auffälligkeiten ausgewertet wird.

12. Vorrichtung nach Anspruch 11, **dadurch gekennzeichnet, dass** durch das zumindest eine Analysemodul (4) die Frequenzspektren (11, 12) jeweils mit einem Referenzfrequenzspektrum (10) verglichen werden.

13. Vorrichtung nach Anspruch 12, **dadurch gekennzeichnet, dass** das Analysemodul (4) bei Abweichen zumindest eines spektralen Anteils des jeweiligen Frequenzspektrums (11, 12) vom Referenzfrequenzspektrum (10) zur Erzeugung eines Fehlererkennungssignals und/oder zur Erzeugung eines die jeweilige Antriebseinheit (3) charakterisierenden Lokalisierungssignals ausgebildet ist.

14. Vorrichtung nach einem der Ansprüche 10 bis 13, **dadurch gekennzeichnet, dass** jeder Antriebseinheit (3) oder einer Gruppe von Antriebseinheiten (3) eine Steuereinheit (5) zugeordnet ist und der Zeitverlauf der die elektrische Leistungsaufnahme der Antriebseinheit (3) charakterisierenden Messgröße und/oder das Frequenzspektrum (11, 12) dieser Messgröße durch die Steuereinheit (5) bereitgestellt wird.

## Claims

1. Method for detecting errors or faults in a machine (1) for processing containers, comprising at least one electrical drive unit (3) for driving a module (2a-2e) of the machine (1), wherein the frequency spectrum of a measured variable characterising the electric power consumption of the drive unit (3) is determined, and wherein, in an analysis step, the frequency spectrum of the measured variable is evaluated in respect of anomalies indicating faults, wherein the frequency spectrum (11, 12) is compared to a reference frequency spectrum (10), wherein, in the event of divergence of at least one spectral portion of the frequency spectrum (11, 12) from the reference frequency spectrum (10), a fault detection signal is generated, and wherein the reference frequency spectrum (10) is a frequency spectrum which was recorded when the machine was in a new state, or a spectrum which was recorded after a period of operation has elapsed after the machine (1) was taken into operation, **characterized in that** the time change of the frequency spectrum (11, 12) is determined on the basis of several reference frequency spectra recorded at different times in the past, by comparing the currently determined frequency spectrum (11, 12) simultaneously with multiple reference frequency spectra (10) determined at different times in the past.

2. Method according to claim 1, **characterised in that** the machine (1) comprises a plurality of drive units (3), that for several or all of these drive units (3) in each case the frequency spectrum (11, 12) is determined of a measured value characterising the power consumption of the drive unit (3), and that, in an analysis step, the frequency spectra of the measured variables are evaluated in respect of anomalies indicating faults.

3. Method according to claim 2, **characterised in that** the frequency spectra (11, 12) are in each case compared with a reference frequency spectrum (10), and that, in the event of divergence of at least one spectral portion of the respective frequency spectrum (11, 12) from the reference frequency spectrum (10), a fault detection signal is generated, and/or a location signal characterising the respective drive unit (3).

4. Method according to claim 1, **characterised in that** the at least one frequency spectrum (11, 12) is determined continuously or at regular intervals of time.

5. Method according to any one of the preceding claims, **characterised in that** amplitude values of the spectral portions of the frequency spectrum (11, 12) which has been determined are compared with threshold values assigned to these spectral portions, and that, in the event of at least one threshold value being exceeded by the amplitude value assigned to this threshold value, the fault detection signal is generated.

6. Method according to any one of the preceding claims, **characterised in that** the frequency spectrum (11, 12) of the measured variable characterising the electric power consumption of the drive unit (3) is obtained from the time characteristic of the amplitude of this measured variable by a transformation into the frequency range.

7. Method according to any one of the preceding claims, **characterised in that** the measured variable characterising the electric power consumption of the drive unit (3) is the electric current.

8. Method according to any one of the preceding claims, **characterised in that** the measured variable characterising the electric power consumption of the drive unit (3) is obtained by analysis of a measured variable characterising the electric power consumption of the entire machine (1), by analysis of a measured variable characterising the electric power consumption of a group of drive units (3), and/or by analysis of a measured variable characterising the electric power consumption of an individual drive unit (3).

9. Method according to any one of the preceding claims, **characterised in that** a control unit (5) is assigned to each drive unit (3) or to a group of drive units (3), and the time characteristic of the measured variable characterising the electric power consumption of the drive unit and/or the frequency spectrum of this measured variable are provided by the control unit (5).

10. Device for detecting faults in a machine (1) for processing containers, comprising at least one electric drive unit (3) for driving a module (2a-2e) of the machine (1), wherein an analysis module (4) is provided, by means of which the frequency spectrum (11, 12) of a measured variable characterising the electric power consumption of the drive unit (3) is determined, and is evaluated in respect of anomalies indicating faults, wherein the frequency spectrum is compared with a reference frequency spectrum (10), wherein the analysis module (4) is configured such as to detect the deviation of at least one spectral portion of the frequency spectrum (11, 12) from the reference frequency spectrum (10) and to generate a fault detection signal, and wherein the reference frequency spectrum (10) is a frequency spectrum recorded in the new state of the machine, or a spectrum which was recorded after a period of operation has elapsed after the machine (1) was taken into operation, **characterised in that** the analysis module (4) is configured to detect the time change of the frequency spectrum (11, 12), based on several reference frequency spectra (10) recorded at different points of time in the past, by comparing the currently determined frequency spectrum (11, 12) simultaneously with multiple reference frequency spectra (10) determined at different times in the past.

11. Method according to claim 10, **characterised in that** the machine (1) comprises a plurality of drive units (3), that one or more analysis modules (4) are provided, by means of which, for some or all of these drive units (3), in each case the frequency spectrum of a measured variable characterising the electric power consumption of the drive unit (3) is determined, and is evaluated with regard to anomalies indicating faults.

12. Method according to claim 11, **characterised in that**, by means of the at least one analysis module (4), the frequency spectra (11, 12) are in each case compared with a reference frequency spectrum (10).

13. Method according to claim 12, **characterised in that** the analysis module (4) is configured such that, in the event of a deviation of at least one spectral portion of the respective frequency spectrum (11, 12) from the reference frequency spectrum (10), it generates a fault detection signal and/or a location signal characterising the respective drive unit (3).

14. Method according to any one of claims 10 to 13, **characterised in that** a control unit (5) is assigned to each drive unit (3) or a group of drive units (3), and the time characteristic of the measured variable characterising the electric power consumption of the drive unit (3) and/or the frequency spectrum (11, 12) of this measured variable is provided by the control unit (5).

## Revendications

1. Procédé d'identification d'erreurs dans une machine (1) pour le traitement de recipients comprenant au moins une unité d'entraînement (3) électrique pour entraîner un ensemble (2a - 2e) de la machine (1), dans lequel le spectre de fréquence d'une grandeur de mesure caractérisant la consommation de puissance électrique de l'unité d'entraînement (3) est déterminé et dans lequel le spectre de fréquence de la grandeur de mesure est évalué quant à la présence d'anomalies pointant des erreurs lors d'une étape d'analyse, dans lequel le spectre de fréquence (11, 12) est comparé à un spectre de référence (10), dans lequel un signal d'identification d'erreur est généré en cas d'écart entre au moins une partie spectrale du spectre de fréquence (11, 12) et le spectre de fréquence de référence (10), et dans lequel le spectre de fréquence de référence (10) est un spectre de fréquence relevé à l'état neuf de la machine ou est un spectre qui a été enregistré après la mise en service de la machine (1) une fois la durée de fonctionnement écoulée, **caractérisé en ce que** la variation dans le temps du spectre de fréquence (11, 12) est déterminée sur la base de plusieurs spectres de fréquence de reference (10) enregistrés par le passé à différents moments, en comparant simultanément le spectre de fréquences (11, 12) déterminé actuellement avec plusieurs spectres de fréquences de référence (10) déterminés dans le passé à différents moments.

2. Procédé selon la revendication 1, **caractérisé en ce que** la machine (1) comprend une pluralité d'unités d'entraînement (3), que respectivement le spectre de fréquence (11, 12) d'une grandeur de mesure caractérisant la consommation de puissance électrique de l'unité d'entraînement (3) est déterminé pour plusieurs ou pour toutes lesdites unités d'entraînement (3), et que les spectres de fréquence des grandeurs de mesure sont évalués, lors d'une étape d'analyse, quant à la présence d'anomalies pointant des erreurs.

3. Procédé selon la revendication 2, **caractérisé en ce que** les spectres de fréquence (11, 12) sont comparés respectivement à un spectre de fréquence de référence (10), et qu'en cas d'écart entre au moins une partie spectrale du spectre de fréquence (11, 12) respectif et le spectre de fréquence de référence (10), un signal d'identification d'erreur et/ou un signal de localisation caractérisant l'unité d'entraînement (3) respective sont générés.

4. Procédé selon la revendication 1, **caractérisé en ce que** l'au moins un spectre de fréquence (11, 12) est déterminé en continu ou à intervalles de temps réguliers.

5. Procédé selon l'une quelconque des revendications précédentes, **caractérisé en ce que** des valeurs d'amplitude des parties spectrales du spectre de fréquence (11, 12) déterminé sont comparées à des valeurs de seuil associées auxdites parties spectrales, et qu'en cas de dépassement d'au moins une valeur de seuil par la valeur d'amplitude associée à ladite valeur de seuil, le signal d'identification d'erreur est généré.

6. Procédé selon l'une quelconque des revendications précédentes, **caractérisé en ce que** le spectre de fréquence (11, 12) de la grandeur de mesure caractérisant la consommation de puissance électrique de l'unité d'entraînement (3) est obtenu à partir de l'évolution dans le temps de l'amplitude de ladite grandeur de mesure par une transformation dans la plage de fréquences.

7. Procédé selon l'une quelconque des revendications précédentes, **caractérisé en ce que** la grandeur de mesure caractérisant la consommation de puissance électrique de l'unité d'entraînement (3) est le courant électrique.

8. Procédé selon l'une quelconque des revendications précédentes, **caractérisé en ce que** la grandeur de mesure caractérisant la consommation de puissance électrique de l'unité d'entraînement (3) est obtenue par analyse d'une grandeur de mesure caractérisant la consommation de puissance électrique de la totalité de la machine (1), par analyse d'une grandeur de mesure caractérisant la consommation de puissance électrique d'un groupe d'unités d'entraînement (3) et/ou par analyse d'une grandeur de mesure caractérisant la consommation de puissance électrique d'une unité d'entraînement (3) individuelle.

9. Procédé selon l'une quelconque des revendications précédentes, **caractérisé en ce qu'**une unité de commande (5) est associée à chaque unité d'entraînement (3) ou à un groupe d'unités d'entraînement (3), et l'évolution dans le temps de la grandeur de mesure caractérisant la consommation de puissance électrique de l'unité d'entraînement et/ou le spectre de fréquence de ladite grandeur de mesure sont fournis par l'unité de commande (5).

10. Dispositif d'identification d'erreurs dans une machine (1) comprenant au moins une unité d'entraînement (3) électrique pour entraîner un ensemble (2a - 2e) de la machine (1), dans lequel est prévu un module d'analyse (4), au moyen duquel le spectre de fréquence (11, 12) d'une grandeur de mesure caractérisant la consommation de puissance électrique de l'unité d'entraînement (3) est déterminé et est évalué quant à la présence d'anomalies pointant des erreurs, dans lequel le spectre de fréquence est comparé à un spectre de fréquence de référence (10), dans lequel le module d'analyse (4) est réalisé pour déterminer l'écart entre au moins une partie spectrale du spectre de fréquence (11, 12) et le spectre de fréquence de référence (10) et pour générer un signal d'identification d'erreur, et dans lequel le spectre de fréquence de reference (10) est un spectre de fréquence relevé à l'état neuf de la machine ou est un spectre qui a été enregistré après la mise en service de la machine (1) une fois une durée de fonctionnement écoulée **caractérisé en ce que** le module d'analyse (4) est réalisé pour déterminer la variation dans le temps du spectre de fréquence (11, 12) sur la base de plusieurs spectres de fréquence de référence (10) relevés par le passé à des moments différents, en comparant simultanément le spectre de fréquences (11, 12) déterminé actuellement avec plusieurs spectres de fréquences de référence (10) déterminés dans le passé à différents moments.

11. Dispositif selon la revendication 10, **caractérisé en ce que** la machine comprend une pluralité d'unités d'entraînement (3), que sont prévus un ou plusieurs modules d'analyse (4), au moyen desquels respectivement le spectre de fréquence d'une grandeur de mesure caractérisant la consommation de puissance électrique de l'unité d'entraînement (3) est déterminé et est évalué quant à la présence d'anomalies pointant des erreurs pour plusieurs ou pour toutes lesdites unités d'entraînement (3).

12. Dispositif selon la revendication 11, **caractérisé en ce que** les spectres de fréquence (11, 12) sont comparés respectivement à un spectre de fréquence de référence (10) par l'au moins un module d'analyse (4).

13. Dispositif selon la revendication 12, **caractérisé en ce que** le module d'analyse (4) est réalisé pour générer un signal d'identification d'erreur et/ou pour générer un signal de localisation caractérisant l'unité d'entraînement (3) respective en cas d'écart entre au moins une partie spectrale du spectre de fréquence (11, 12) respectif et le spectre de fréquence de référence (10).

14. Dispositif selon l'une quelconque des revendications 10 à 13, **caractérisé en ce qu'**une unité de commande (5) est associée à chaque unite d'entraînement (3) ou à un groupe d'unités d'entraînement (3), et l'évolution dans le temps de la grandeur de mesure caractérisant la consommation de puissance électrique de l'unité d'entraînement (3) et/ou le spectre de fréquence (11, 12) de ladite grandeur de mesure sont fournis par l'unité de commande (5).
